(19) Europäisches Patentamt
European Patent Office
Office européen des brevets

(11) **EP 1 261 137 B1**

(12) **EUROPÄISCHE PATENTSCHRIFT**

(45) Veröffentlichungstag und Bekanntmachung des Hinweises auf die Patenterteilung:
**01.10.2008 Patentblatt 2008/40**

(51) Int Cl.:
***H03M 5/16*** *(2006.01)*    ***H03M 5/14*** *(2006.01)*

(21) Anmeldenummer: **02006726.0**

(22) Anmeldetag: **23.03.2002**

(54) **Verfahren zum Kodieren und Dekodieren von Datenströmen**

Method for coding and decoding a data stream

Procédé de codage et de décodage de flux de données

(84) Benannte Vertragsstaaten:
**AT CH DE LI**

(30) Priorität: **21.05.2001 DE 10124934**
**28.09.2001 DE 10148275**

(43) Veröffentlichungstag der Anmeldung:
**27.11.2002 Patentblatt 2002/48**

(73) Patentinhaber: **Techem Energy Services GmbH**
**65760 Eschborn (DE)**

(72) Erfinder: **Hansing, Martin, Dipl.-Inf.**
**65931 Frankfurt/am Main (DE)**

(74) Vertreter: **KEIL & SCHAAFHAUSEN**
**Patentanwälte**
**Cronstettenstraße 66**
**60322 Frankfurt am Main (DE)**

(56) Entgegenhaltungen:
**US-A- 5 271 016        US-A- 5 454 006**
**US-B1- 6 198 413**

**Beschreibung**

Die vorliegende Erfindung betrifft Verfahren zum Kodieren und Dekodieren von Datenströmen, bei dem zur Kodierung aus Quelldatenströmen ein binärer Code erzeugt und zur Dekodierung der binäre Code in die Quelldatenströme zurückverwandelt wird.

Zur Zeit gibt es zahlreiche Kodierverfahren, um gleichspannungsfreie RLL-Codes zu erzeugen. Viele der Verfahren arbeiten aus praktischen Erwägungen mit Codeworten konstanter Länge (Blockkodierung). Ist die Anzahl der Quellsymbole bzw. die Menge der Codeworte begrenzt und aufzählbar, so werden oftmals Tabellen zur Kodierung und Dekodierung eingesetzt. Für die Aufzeichnung von Daten auf optischen oder magnetischen Medien (CD, DAT, DVD) sind EFM und EFMPlus bekannte Kodierverfahren. Klassische binäre Kodierverfahren zur Erzeugung gleichspannungsfreier Signale sind der Manchester-Code, der Differential-Manchester-Code, 3-aus-6, 8B10B (US 4,486,739) und CMI (coded mark inversion). Diese Verfahren arbeiten mit zwei Signalzuständen ("0" und "1"). Ferner sind nichtbinäre Kodierverfahren bekannt, wie der AMI-Code, der modifizierte AMI-Code, HDB-3 (PCM30-Übertragungsstrecken), der 4B3T-Code (ISDN national), MMS43 (ISDN Europa) oder das spektrale Trellis-Shaping.

Existierende Verfahren zur Erzeugung lauflängenbeschränkter Codes erfüllen nicht die Anforderungen spezieller Anwendungen. Entweder ist die Codeeffizienz nachteilig, die Codewortlänge passt nicht, die Disparität liegt über den Erfordernissen öder das Kodierverfahren ist für Low-Performance-Produkte zu aufwendig.

So ist bspw. in der US 5,271,016 ein Verfahren zur Erzeugung eines lauflängenbeschränkten RLL-Codes angegeben, bei dem ein binärer Ursprungscode in einen temären Code konvertiert und jedem Zeichen des temären Codes eine fest vorgegebene Binärkombination zur Erzeugung eines lauflängenbeschänkten Codes zugeordnet wird.

Insbesondere ist für die Funkübertragung eine Leitungskodierung mit kleiner Disparität von Vorteil, um beim Funkempfänger die Drift der Pegelschwellen im Demodulator (data slicer) möglichst klein zu halten. Einfach und platzsparend lässt sich z. B. der 3-aus-6-Code realisieren. Es werden dabei 4 Bit lange Quellsymbole in 6 Bit lange Codeworte umgesetzt. Der Nachteil der 3-aus-6-Kodierung ist seine mäßige Effizienz; sie beträgt $^4/_6$ = 66,7%; der Kodierverlust also 50%. Dies kann sich beispielsweise bei batteriebetriebenen Geräten mit Funkdatenübertragung negativ auf die Lebensdauer und/oder Kosten auswirken.

Andere Kodierverfahren, wie 8B10B, haben eine höhere Codeeffizienz (E = 8/10 = 80%), sind aber sehr viel aufwendiger zu realisieren, da hier größere Codeworttabellen und komplexe logische Verknüpfungen benötigt werden.

Allgemein scheitert die Kodierung mittels Tabellen bei größeren Codewortlängen an der exponentiell wachsenden Anzahl von Codeworten. Es wurden daher Verfahren zur Aufzählung ("Enumeration") von Codeworten angegeben (s. Kautz 1965, Pátrovics u. Schouhamer Immink 1996). Aufzählende Dekodierung wird über gewichtete Summen von Einzelsymbolen empfangener Codeworte realisiert. Die Schwierigkeit bei diesem Verfahren besteht in der Bestimmung der Gewichtskoeffizienten. Häufig werden zwei Sätze von Koeffizienten benötigt (s. Tang u. Bahl 1970), deren Ermittlung eine intellektuelle Herausforderung im Fachgebiet Kombinatorik ist. Mit zunehmender Codewortlänge nimmt die Anzahl der Gewichtskoeffizienten und gleichzeitig die Länge ihrer binären Repräsentation zu. Der Speicherbedarf für die Realisierung eines Aufzählungsverfahrens mit Gewichtskoeffizienten wächst daher mit zunehmender Codewortlänge quadratisch an und stößt somit schnell an praktische Grenzen.

Nichtbinäre Kodierverfahren, wie AMI u. a., sind nicht anwendbar, wenn die zur Verfügung stehende Hardware nur zwei Signalzustände verarbeiten kann.

Aufgabe der Erfindung ist es, Verfahren zum Kodieren und Dekodieren von Datenströmen anzugeben, die einfach und kompakt realisierbar sind, eine hohe Kodiereffizienz aufweisen und einen zur Funkübertragung mit einfachen technischen Übertragungsgeräten geeigneten Code mit vorgebbarer niedriger Disparität erzeugen.

Diese Aufgabe mit Verfahren gemäß den Ansprüchen 1 und 2 gelöst. Dabei wird zur Kodierung der Datenströme ein Quelldatenstrom in einen ternären Datenstrom konvertiert und aus dem temären Datenstrom (Zahlen zur Basis 3) mittels Zustandsübergängen der binäre Code gebildet, wobei der binäre Code eine maximale Lauflänge von vier aufeinanderfolgenden gleichen diskreten Signalzuständen und eine maximale Disparität von zwei diskreten Abweichungen von der Pegelmitte zweier Signalzustände oder von dem Nullpegel aufweist. Der binäre Code wird zur Dekodierung mittels entsprechender Zustandsübergänge in den ternären Datenstrom überführt und in den Quelldatenstrom konvertiert.

Damit wird aus einem Eingabedatenstrom (Quelldatenstrom) ein binärer gleichspannungsfreier und lauflängenbeschränkter Code erzeugt. Durch die vorherige Umwandlung in einen temären Datenstrom lassen sich besonders einfach Zustandsübergänge festlegen, die ohne das Festlegen von speicherintensiven Codeworten die Erzeugung eines binären Codes ermöglichen. Die Kodiereffizienz E ist das Verhältnis der Länge n der Quellsymbole in Bits zur Länge k der Codeworte bzw. kodierten Nachricht in Bits

$$E = \frac{n}{k}, \ bzw. \ E = \frac{\log_2(N)}{k},$$

wobei N ist die Anzahl gleichwahrscheinlicher Quellsymbole ist. Damit wird der als relative Verlängerung einer Quellnachricht der Länge n Bit durch die Kodierung in eine Codesequenz der Länge k Bit bezeichnete Kodierverlust V

$$V = \frac{k - n}{n} = \frac{k}{n} - 1 = \frac{k}{\log_2(N)} - 1 = \frac{1}{E} - 1$$

minimiert. Dies führt insbesondere bei batteriebetriebenen Geräten mit Funkdatenübertragung zu einer verbesserten Batterieausnutzung und damit zu einer höheren Betriebsdauer und/oder geringeren Kosten.

Unter den Randbedingungen einer maximalen Disparität des erzeugten Codes von höchstens $D_{MAX} = \pm 2$ und einer Lauflänge von maximal $RL_{MAX} = 4$ lässt sich die optimale Grenzeffizienz $E_\infty$ des Kodierverfahrens angeben. Sie liegt bei $E_\infty \approx 79,25\%$. Der theoretisch erreichbare minimale Codierverlust $V_\infty$ bei $E_\infty$ beträgt ungefähr 26,2%.

Erfindungsgemäß bilden die Zustandsübergänge einzelne Ziffern ("0", "1", "2") der Ternärdarstellung des Datenstroms auf jeweils zwei Binärstellen des binären Codes ("OO", "OI", "IO" oder "11") ab.

Um eine eindeutige Abbildung zwischen Ternär- und der Binärdarstellung zu erhalten, hängt die Definition der Zustandsübergänge von der laufenden Disparität des Datenstroms ab. Die laufende Disparität ergibt sich dabei aus der Gesamtparität des bisher berücksichtigten binären Codeworts. Wenn ausgehend von einer Gleichspannungsfreiheit bspw. ein binärer Signalzustand "0" die Disparität D = -1 und ein binärer Signalzustand "1" die Disparität D = +1 erzeugt, hat ein binäres Codewort "OOI" in der Summe die Gesamtdisparität D = -1. Durch Hinzufügen der Binärkombination "II" zu einem binären Codewort "IIOOI" wird die Gesamtdisparität (laufende Disparität) auf D = +1 verändert. Wenn nun der Zustandsübergang T2 bspw. derart von der laufenden Disparität D abhängt, dass bei D<0 T2 die ternäre Zahl "2" auf die Binärkombination "II" und bei D>0 auf die Binärkombination "OO" abbildet, wird durch die Zustandsübergänge T0, T1 und T2 eine eindeutige Abbildung zwischen den ternären Zuständen "0", "1", "2" und den binären Zuständen "OI", "IO", "OO" bzw. "II" erreicht.

Zur Erzeugung der Startdisparität kann erfindungsgemäß ein Startbit oder die Disparität einer vorherigen Bitsequenz verwendet werden, um einen definierten Anfangszustand zu schaffen.

Insbesondere bei Computeranwendungen liegt der Quelldatenstrom als binärer Quellcode vor. In diesem Fall wird der binäre Quelldatenstrom erfindungsgemäß in Blöcken vorgegebener Blocklänge in den ternären Datenstrom konvertiert. Vorzugsweise liegt die Blocklänge des binären Codes für die Konversion in den ternären Datenstrom bei 11, 19 oder 84 Bit, weil bei dieser Wahl die Kodiereffizienz sehr nah am erreichbaren Optimum liegt.

Indem dem in binären Code konvertierten Datenstrom erfindungsgemäß eine SYNC-Sequenz vorangestellt wird, wird eine Erkennung des Beginns einer neuen pegelmäßig stärkeren Funkbotschaft ermöglicht, die einer regelmäßig schwächeren Nachricht überlagert ist. Für den Fall sich überlagernder Nachrichten, der beim ungeregelten Funkbetrieb auftreten kann, wird so eine Möglichkeit geschaffen, um eine Kollision von Funkbotschaften zu erkennen. Bei ausreichend starken Empfangspegelunterschieden kann sich die stärkere der beiden Funkbotschaften durchsetzen.

Dazu weist die SYNC-Sequenz vorzugsweise eine Taktsequenz mit einer Folge alternierender Signalpegel und eine Startsequenz mit einer größeren Lauflänge von aufeinanderfolgenden gleichen Signalzuständen als die maximale Lauflänge des Datenstroms aufweist. Aufgrund der größeren Lauflänge kann die Startsequenz in dem Datenstrom einfach identifiziert werden.

Um einen kodierten Datenstrom einfach an die Startsequenz anhängen zu können, endet die Startsequenz erfindungsgemäß mit einer definierten Disparität, insbesondere mit der Disparität null oder einer einfach positiven oder negativen Disparität. So ist der Startzustand genau definiert.

Nachfolgend wird ein bevorzugtes Kodier- und Dekodierverfahren mit Bezug auf die Zeichnung näher beschrieben. Dabei ergeben sich aus der Beschreibung und/oder der Zeichnung weitere erfindungsgemäße Vorteile und Merkmale, unabhängig von ihrer Zusammenfassung in den Ansprüchen oder deren Rückbezügen.

Es zeigen:

Fig. 1        eine Tabelle mit einem Überblick über die Anzahl der Codeworte $C_D(2n)$ mit Lauflängenbeschränkung mit ausgewogenem 0/1 Bitverhältnis für die verschiedenen Disparitäten;

Fig. 2      ein Aufbauschema eines binären Codes für ein Codewort mit 16 Bit Länge mit einer Lauflängenbegrenzung $RL_{MAX} = 4$ und einer maximalen Disparität $D_{MAX} = +/- 2$;

Fig. 3      einen Zustandsautomat zur Erzeugung des binären Codes gemäß Fig. 2;

Fig. 4a und b      den Aufbau einer SYNC-Sequenz;

Fig. 5      einen Zustandsautomat für die Empfangskodierung des binären Codes gemäß Fig. 2;

Fig. 6      den Netto-Kodierungsoverhead von RLL-Code als Funktion der Codewortlänge;

Fig. 7      die Netto-Kodierungseffizienz von RLL-Code als Funktion der Codewortlänge und

Fig. 8      die prozentuale Abweichung von der Gleichspannungsfreiheit von RLL-Code als Funktion der Codewortlänge.

Das im Folgenden beispielhaft beschriebene Verfahren zum Kodieren und Dekodieren von Datenströmen ist insbesondere geeignet, einen gleichspannungsfreien Signalstrom mit begrenzter Lauflänge zu generieren. Ein gleichspannungsfreier Signalstrom wird beispielsweise für die Modulation eines hochfrequenten Trägers zur Funkdatenübertragung oder für die leitungsgebundene Datenübertragung auf speisespannungsführenden Leitungen benötigt. Der Anwendungsschwerpunkt des erfindungsgemäßen Verfahrens liegt auf der Erzeugung von effizienten Funktelegrammen für die Messdatenübertragung.

Eine elementare Bedingung für die Gleichspannungsfreiheit von binären Codes ist, dass - in der Summe - die Dauer eines Signalzustandes gleich der Dauer des komplementären Signalzustandes ist. Für eine Datenübertragung mit diskreten, konstanten Schritttakten in Binärkodierung bedeutet dies, dass die Anzahl n von O-Bits gleich der Anzahl n von I-Bits sein muss. Die Länge der Codeworte sei bspw. 2n. Dann ist die Anzahl C(2n) der Codeworte mit ausgewogenen O/I-Bitverhältnis ohne Lauflängenbeschränkung

$$C(2n) = \binom{2n}{n}, \quad mit \quad n \in \mathbf{N}.$$

Führt man für die Kodierung eine Beschränkung der Anzahl aufeinander folgender gleicher Signalzustände (Lauflängenbeschränkung, RLL-Code) über die Abweichung eines Signalstroms von der Pegelmitte zweier Signalzustände bzw. dem Nullpegel (Disparität $D = D_{MAX}$) ein, dann ist die Anzahl $C_D(2n)$ erzeugbarer Codeworte der Länge 2n Bit

$$C_D(2n) = \binom{2n}{n} + \sum_{i=1}^{n-1}(-1)^i \binom{2n}{n-(D+1)i},$$

$$mit \quad \binom{n}{m} \overset{Def}{=} 0 \quad \text{für } (m < 0) \vee (m > n).$$

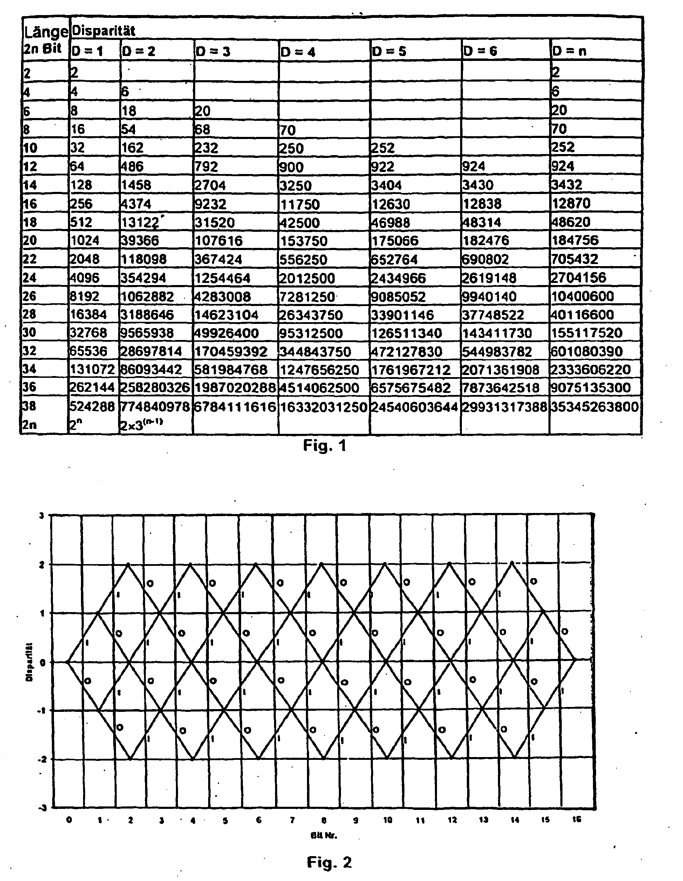

Fig. 1 zeigt eine Tabelle mit einem Überblick über die Anzahl der Codeworte $C_D(2n)$ unterschiedlicher Länge für verschiedene Disparitäten.

Für Disparitäten D = 1 und D = 2 lässt sich $C_D(2n)$ leicht angeben. Insbesondere ist das Verhältnis von $C_2(2n)$ /$C_2(2n-2)$ konstant; d. h. eine systematische Konstruktion der Codes liegt nahe. Der Fall D = 1 ist aus Gründen der Kodiereffizienz (E = 50%, wie z. B. Manchester-Code) uninteressant. Für den Fall D = 2 ergibt sich eine optimale Grenzeffizienz $E_\infty$ von

$$E_\infty = \lim_{n \to \infty} \frac{\log_2(2 \cdot 3^{n-1})}{2n} = \lim_{n \to \infty} \frac{\log_2(2) + (n-1)\log_2(3)}{2n}$$

$$E_\infty = \lim_{n \to \infty} \frac{1}{2n} + \lim_{n \to \infty} \frac{n \log_2(3)}{2n} - \lim_{n \to \infty} \frac{\log_2(3)}{2n}$$

$$E_\infty = 0 + \frac{\log_2(3)}{2} - 0 \approx 0{,}79248125 \approx 79{,}25\% \;.$$

Der Kodierverlust bei der Grenzeffizienz beträgt:

$$V_\infty = \frac{1}{E_\infty} - 1 \approx 0{,}26185951 \approx 26{,}2\% \;.$$

Nachfolgend werden nun der Aufbau und die Erzeugung des binären Codes mit einer Lauflängenbeschränkung $RL_{MAX} = 4$ und einer maximalen Disparität $D_{MAX} = 2$ detailliert beschrieben. Fig. 2 zeigt schematisch die Möglichkeiten zur Erzeugung eines derartigen binären Codes, wobei die Gesamtdisparität des Codeworts gegen die Anzahl der Bits dargestellt ist.

Ausgangspunkt vor dem Setzen des ersten Bits ist eine Disparität von D = 0. Wenn das erste Bit bspw. ein I-Bit ist, hat die Disparität den Wert D = +1. Ist auch das zweite Bit ein I-Bit erreicht die Disparität den maximalen Wert D = +2. Um innerhalb der Grenzen der maximalen Disparität zu bleiben, besteht als Möglichkeit für das nächste Bit nur das Setzen eines O-Bits. Es können nun maximal 4 O-Bits gesetzt werden, um bei dem unteren Grenzwert der Disparität bei D = -2 anzukommen. Aus dem Diagramm ist ersichtlich, dass der erzeugte Code höchstens 4 gleiche Einzelsymbole "O" oder "I" in Folge aufweist, also eine maximale Lauflänge von $RL_{MAX} = 4$ hat. Die Disparität bewegt sich in den Grenzen von +2 bis -2 und ist am Ende D = 0; der Code also DC-frei (gleichspannungsfrei).

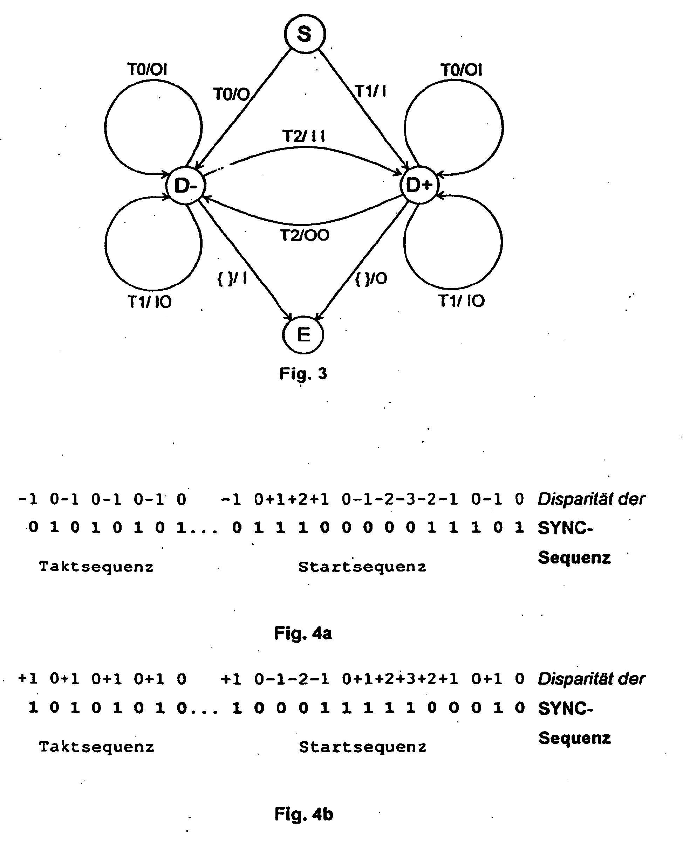

Es lässt sich nun ein Zustandsautomat angeben, der geeignet ist, Eingangsdatenströme beliebiger Länge in gleichspannungsfreie Ausgangsdatenströme (Codes) mit den gewünschten Eigenschaften $D_{MAX} = 2$ und $RL_{MAX} = 4$ zu konvertieren. Ein solcher Zustandsautomat ist in Fig. 3 dargestellt.

Ausgangspunkt für den Zustandsautomaten ist ein nicht dargestellter Eingangsdatenstrom. Dieser kann in Abhängigkeit von der in ihm enthaltenen Information beliebige Werte haben und binär dargestellt werden. Beispielsweise können folgende binär dargestellten Eingangsdaten angenommen werden:

Eingangsdaten binär    I I I I I I I I I I I I I I I I I I I    Bit, Wert: $2^{19}$-1).

Diese Eingangsdaten werden in einem ersten, ebenfalls nicht dargestellten Zwischenschritt in eine ternäre Zahl (Zahl mit Ziffern der Basis 3) konvertiert und erhalten dadurch folgendes Aussehen:

Zwischenschritt ternär    2 2 2 1 2 2 0 1 2 0 0 1.

Ohne Beschränkung der Allgemeinheit befindet sich der Zustandsautomat in einem der Zustände positiver oder negativer Disparität (D+ oder D-). Die Zustände D+ bzw. D- können anfangs durch eine definierte SYNC-Sequenz oder ausgehend vom Startzustand S durch die Zustandsübergänge T0 oder T1 mit einem gesonderten Startdatenbit erreicht werden. Je nachdem, ob dieses erste Bit den Wert "O" oder "I" hat werden die Zustände D- bzw. D+ erreicht. Im Startzustand sind die Zustandsübergänge dabei wie folgt definiert:

T0(S):    setze im binären Ausgangscode das Bit "O" und
T1(S):    setze im binären Ausgangscode das Bit "I".

Im vorliegenden Beispiel sei das erste Bit des Eingangscodes eine "I" und der Zustandsübergang T1 wird angewendet. Dieser setzt im Ausgangscode ein I-Bit und erzeugt damit ein Codewort mit positiver Disparität. Der Zustandsautomat befindet sich daher im Zustand positiver Disparität D+.

Nun nimmt der Zustandsautomat die erste Ziffer (im Beispiel von rechts) des ternären Zwischenschritts und ordnet sie einem der Zustandübergänge

T0(D+):     setze im binären Ausgangscode die Bitfolge "O I",
T1(D+):     setze im binären Ausgangscode die Bitfolge "I O" oder
T2(D+):     setze im binären Ausgangscode die Bitfolge "O O"

zu, wobei die Ziffer "0" dem Zustandsübergang T0, die Ziffer "1" T1 und die Ziffer "2" T2 zugeordnet wird.

Im Beispiel ist die erste ternäre Ziffer von rechts eine "1". Daher setzt der Zustandsübergang T1(D+) im Ausgangscode die Bitfolge "I O" hinzu. Das gesamte Ausgangscodewort lautet danach "I O I" und weist ebenfalls eine einfach positive Disparität D+ auf. Für die nächsten beiden ternären Ziffern "0" fügt der Zustandsübergang T0(D+) dem Ausgangswort jeweils die Bitfolge "O I" hinzu, so dass insgesamt das Codewort "O I O I I O I" entsteht, das ebenfalls positive Disparität aufweist. Mit der folgenden ternären Zahl "2" wird nun der Zustandsübergang T2(D+) angewendet und fügt die Bitfolge "O O" hinzu zu dem Gesamtcodewort "O O O I O I I O I". Diese Wort hat nun negative Disparität D-.

Bei Zuständen negativer Disparität D- sind die Zustandsübergänge nun wie folgt definiert:

T0(D-):     setzte im binären Ausgangscode die Bitfolge "O I",
T1(D-):     setzte im binären Ausgangscode die Bitfolge "I O" oder
T2(D-):     setze im binären Ausgangscode die Bitfolge "I I".

Für die folgende ternäre Zahl "1" wird daher der Zustandsübergang T1(D-) angewendet. Bei entsprechender Anwendung der Zustandsübergänge erhält man damit schließlich den folgenden Ausgangscode, wobei beim Wortende der Zustandsübergang {}(D+) → "O" oder {}(D-) → "I" zum Erreichen eines gleichspannungsfreien Endzustands E angewendet wird:

Ausgangscode binär     O I I O O I I I O O O I I O I I O O O O I O I I O I

Im zuvor beschriebenen Beispiel wurde davon ausgegangen, dass die gesamten zu konvertierenden Eingangsdaten aus einer Folge von 19 Bits und einem zusätzlichen Startbit bestehen. In der Praxis sind die Eingangsdaten in der Regel länger. Die Konvertierung großer Zahlen vom Dualsystem (Zweiersystem) ins Ternärsystem (Dreiersystem) bereitet zwar prinzipiell keine Schwierigkeiten, sie geht jedoch mit einem zunehmenden Rechenaufwand einher. Eine Erleichterung bringt daher die Zerlegung der Eingangsdaten in Blöcke fester Länge. Dabei werden die Blocklängen so gewählt, dass in der entsprechenden Ternärdarstellung der Verschnitt möglichst klein wird, d.h. der Zahlenbereich der Ternärdarstellung mit gegebener Stellenzahl gut ausgenutzt wird.

Bei blockweiser Kodierung kann von dem Startzustand S in einen der Arbeitszustände D- bzw. D+ übergegangen werden, indem das erste Bit des Ausgangsdatenstroms fest oder zufällig oder das erste Bit des Eingangsdatenstroms für die Übergänge T0 bzw. T1 gewählt wird.

Zu Beginn der Konvertierung, d.h. bei dem ersten zu konvertierenden Block, wird also eine Disparität D+ bzw. D- vorgegeben. Bei allen folgenden Eingangsdaten und auch über Blockgrenzen hinweg bewegt man sich nur innerhalb der beiden Zustände D+ und D-. Erst am Ende des Kodiervorgangs, d.h. nach der Kodierung des letzten Blocks von Eingangsdaten, wird die Disparität beseitigt, indem ein letztes Bit zur Erzeugung vollständiger Gleichspannungsfreiheit angehängt wird. Die Zustände S und E des Zustandsautomaten sind in diesem Fall für die Kodierung eines einzelnen Datenblocks irrelevant mit der Konsequenz, dass am jeweiligen Blockende keine vollständige Gleichspannungsfreiheit erreicht wird, sondern erst am Nachrichtenende.

Ist der Eingangsdatenstrom binär und besteht aus b Bits, dann kann also 1 Bit zur Erzeugung der Startdisparität D+ bzw. D- direkt verwendet werden. Betrachtet man die übrigen (b-1) Bit als Binärzahl, dann kann diese durch eine Basiskonversion von Dualsystem in das Temärsystem (Zahlen zur Basis 3) überführt werden. Die einzelnen Ziffern 0, 1 und 2 der Ternärdarstellung können nun direkt als Eingangsbedingungen T0, T1 und T2 der Zustandsübergänge dienen. Um den Rechenaufwand klein zu halten, ist es sinnvoll die restlichen (b-1) Bit der Dualdarstellung in Blöcken zu konvertieren. Geeignete Blocklängen sind solche, deren Zweierpotenz nur wenig kleiner ist als eine ganzzahlige Dreierpotenz:

$$2^n \approx 3^m \quad \wedge \quad 2^n \leq 3^m \quad mit \ n,m \in \mathbb{N},$$

insbesondere

$$2^{11} = 2048 \approx 2187 = 3^7 \text{ bzw.}$$

$$2^{19} = 524288 \approx 531441 = 3^{12} \text{ bzw.}$$

$$2^{84} = 19342813113834066795298816 \approx 19383245667680019896796723 = 3^{53}.$$

Die Codeeffizienz ist für den Fall $(2^{11} \leftrightarrow 3^7)$ $E_{11/7} = 11/(2\times7) \approx 78,571\%$, für den Fall $(2^{19} \leftrightarrow 3^{12})$ $E_{19/12} = 19/(2\times12) \approx 79,167\%$ und für den Fall $(2^{84} \leftrightarrow 3^{53})$ $E_{84/53} = 84/(2\times53) \approx 79,245\%$.

Daher ist es bspw. vorteilhaft, den zu kodierenden Datenstrom in 11-Bit-Worte aufzuteilen und diese blockweise in eine 7-stellige Ternärdarstellung zu konvertieren. In einer weiteren Variante ist auch eine Aufteilung der binären Eingangsdaten in 19-Bit-Worte möglich, die in eine 12-stellige Ternärdarstellung konvertiert werden. In einer dritten Variante wird eine Aufteilung der binären Eingangsdaten in 84-Bit-Worte vorgeschlagen, die in eine 53-stellige Ternärdarstellung konvertiert werden. In allen drei Fällen werden die ternären Ziffern {"0", "1", "2"} abhängig von der laufenden Disparität D (dem Zustand D+ oder D-) ohne Zwischenschritt in die vier möglichen Ausgangszustände {"OO", "OI", "IO", "I I"} überführt.

Es ist jedoch auch möglich, den Zustandsautomaten vollständig auf jeden Block einzeln anzuwenden. Vorzugsweise würden dann die Bit-Datenblöcke in einer Länge von 11+1, 19+1 bzw. 84+1 Bit gewählt, wobei das zusätzliche Bit zum Verlassen des Startzustands S dient. Aus einem 11+1 Bit-Datenblock wird durch Kodierung so ein 1 + 2*7 + 1 = 16 Bit RLL-Codewort, aus 19+1 Bit werden 1 + 2*12 + 1 = 26 Bit und aus 84+1 Bit werden 1 + 2*53 + 1 = 108 Bit. Man erzielt hierbei nach jedem Datenblock Gleichspannungsfreiheit auf Kosten längerer Codeworte und einer Verschlechterung der Kodiereffizienz ($E_{11+1} = 12/16 < E_{11/7} = 11/(2\times7)$; $E_{19+1} = 20/26 < E_{19/12} = 19/(2\times12)$; $E_{84+1} = 85/108 < E_{84/53} = 84/(2\times53)$).

Zustandsautomaten mit äquivalenten Eigenschaften ergeben sich durch Vertauschen der Eingangsbedingungen T0, T1 und T2 in den Zustandsübergängen.

Für das Anwendungsgebiet der Funkdatenübertragung gelten spezielle Randbedingungen. In Systemen mit mehreren gleichberechtigten Sendern, deren Funkaussendungen nicht koordiniert sind, können Kollisionen der Funkbotschaften auftreten. Eine Anforderung an solche Systeme ist, dass durch Kollision gestörte Funkbotschaften erkannt werden. Weiterhin sollten Funkbotschaften mit stärkerem Empfangspegel, die von Botschaften mit schwächerem Empfangspegel überlagert sind, bei ausreichendem Störabstand empfangen werden können. Insbesondere soll während des Empfangs einer Funkbotschaft eine zeitlich später eintreffende Funkbotschaft mit stärkerem Empfangspegel dazu führen, dass der laufende Empfang als gestört erkannt und abgebrochen wird und die neue überlagerte, stärkere Botschaft empfangen wird. Dazu wird den eigentlichen Daten eine SYNC-Sequenz vorangestellt, die einem Funkempfänger dazu dient, sich auf die Signalstärke der empfangenen Funkbotschaft einzustellen und anhand einer definierten binären Signalsequenz den Schritttakt für den nachfolgenden Informationsteil zu gewinnen.

Die SYNC-Sequenz setzt sich aus einer Taktsequenz und einer Startsequenz zusammen. Die Taktsequenz ist eine als Folge alternierender Signalpegel definierte Schrittfrequenz. Die Taktsequenz ist so lang zu wählen, dass ein Empfänger am Ende der Taktsequenz einen stabilen Betriebszustand erreicht hat. Auf die Taktsequenz folgt die Startsequenz. Sie wird als Signalfolge definiert, die eindeutig von dem RLL-Datenstrom unterscheidbar ist. Da es bei der beschriebenen Kodierung keine reservierten Codeworte mit zulässiger Lauflänge $RL_{MAX} = 4$ gibt, weist die Startsequenz eine größere Lauflänge als der RLL-Code auf, d. h. $RL_{MAX} > 4$. Möglichkeiten für den Aufbau der SYNC-Sequenz sind in den Fig. 4a und 4b dargestellt.

Die Unterscheidbarkeit der SYNC-Sequenzen von dem RLL-Datenstrom ist durch fünf aufeinanderfolgende Nullen (Fig. 4a) bzw. durch eine Folge von fünf Einsen (Fig. 4b) gegeben. Die Disparität am Ende der SYNC-Sequenz ist Null, so dass sich ein durch den Zustandsautomaten kodierter Datenstrom nahtlos anfügen lässt.

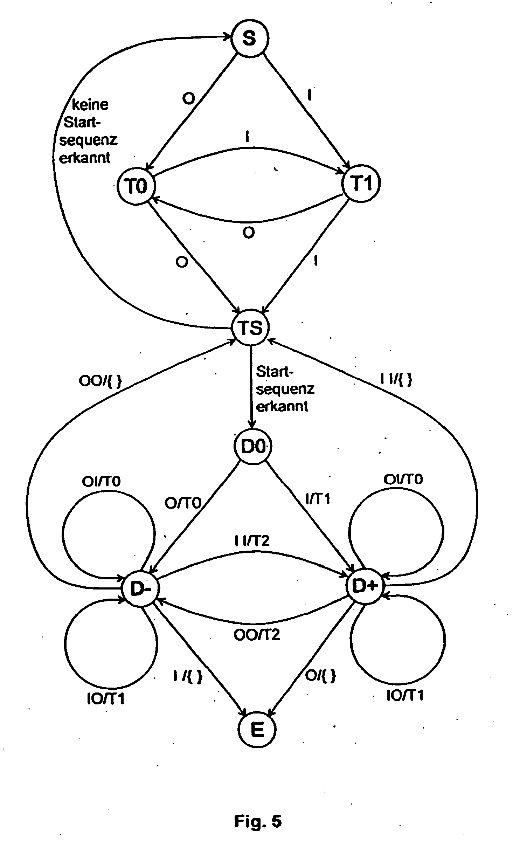

Ein Zustandsautomat für die Empfangsdekodierung ist in Fig. 5 dargestellt. Er dient dazu, den binären Code wieder in den ursprünglichen Quellcode zurückzuübersetzen. Das Funktionsprinzip ist dem Funktionsprinzip des in Fig.

3 dargestellten Zustandsautomaten zur Erzeugung des binären Codes vergleichbar, wobei der vorliegende Zustandsautomat auch die SYNC-Sequenz erkennen kann.

Ausgehend von dem Startzustand werden durch Abtastoperatoren "O" und "I" zunächst die Bitwechsel in der Taktfrequenz verfolgt, die regelmäßig zwischen den Zuständen B0 für das Bit "O" und B1 für das Bit "I" wechseln. Sobald der regelmäßige Bitwechsel durch zwei aufeinanderfolgende Bits unterbrochen wird, wird in der Stufe TS ein Test auf Vorliegen der definierten Startsequenz durchgeführt. Bis in der Stufe TS eine gültige Startsequenz erkannt wird, werden die vorbeschriebenen Schritte wiederholt.

Nach dem Erkennen einer Startsequenz wird zum Erkennen der Daten zunächst in einen Zustand D0 mit der Disparität D = 0 übergegangen, die vor dem Auslesen des binären Datencodes besteht. Um den Anfangszustand der Disparität (D- oder D+) zu erkennen, wird zunächst das als Startbit zur Festlegung der Startparität verwendete erste Bit durch die Operatoren "O" bzw. "I" bestimmt. Dadurch gelangt man in den Zustand negativer (D-) oder positiver (D+) Disparität. Nachfolgend werden jeweils die nächsten zwei Bit als Bitfolge ausgelesen und durch die nachfolgenden Zustandsübergänge in ternäre Ziffern übersetzt:

OI(D-/D+)    setze ternäre Ziffer T0 = "0",
IO(D-/D+)    setze ternäre Ziffer T1 = "1",
II(D-)       setze ternäre Ziffer T2 = "2" und
OO(D+)       setze ternäre Ziffer T2 = "2".

Ferner sind Zustandsübergänge OO(D-) bzw. II(D+) definiert. Wenn diese Zustandsübergänge aufgrund der im binären Code vorgegebenen Bitfolge angewendet werden müssen, ist dort ein Zustand mit einer Disparität aufgetreten, der größer ist als die vorgegebene maximale Disparität $D_{MAX}$ = 2. Dies bedeutet, dass das Datenwort (z.B. durch Überlagerung) gestört ist. Daher werden von diesen Zustandsübergängen als Ausgangsdaten die "Ende der Nachricht"-Anweisung {} gesetzt und der Zustandsautomat in den Zustand TS überführt, um das Vorliegen einer neuen Startsequenz zu überprüfen.

Wenn in dem Datenstrom nur noch ein Bit vorhanden ist, bedeutet dies das Ende der zu dekodierenden Daten. In diesem Fall wird der Zustandsautomat durch Operatoren "I" bzw. "O" in den Endzustand E überführt.

Anschließend wird die ternäre Zahl in den Quellcode zurückkonvertiert.

Zwecks einfacherer Implementierbarkeit wird eine Variante vorgeschlagen, bei der die SYNC-Sequenz mit einfach positiver bzw. einfach negativer Disparität endet und die Kodierung des Quelldatenstroms in dem Zustand "D-" bzw. "D+" beginnt. Dies erspart bei der Realisierung des Kodierverfahrens den Startzustand "S" und beim Dekodieren den Zustand "D0".

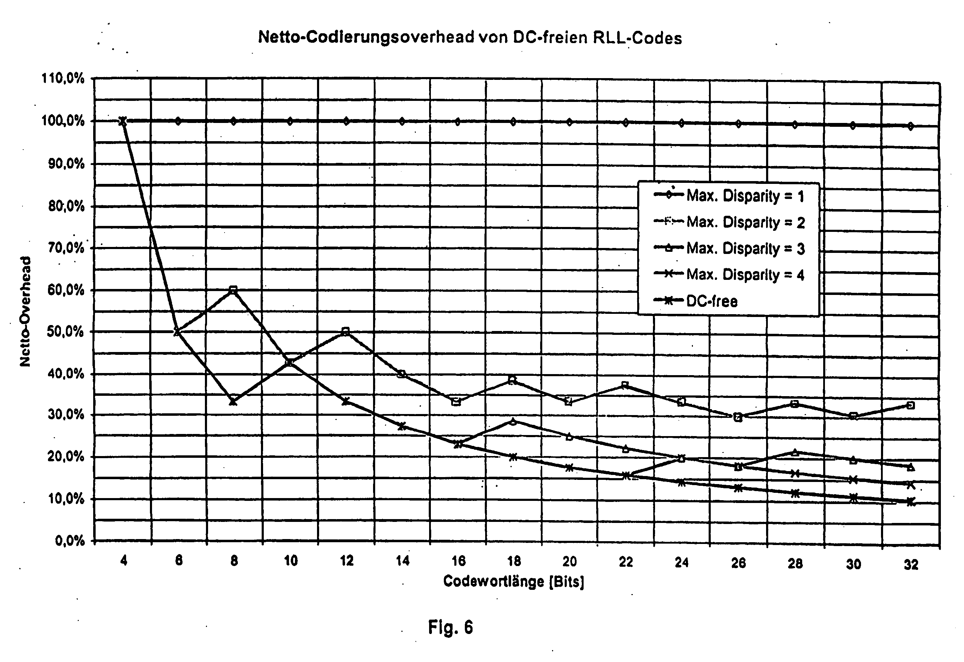

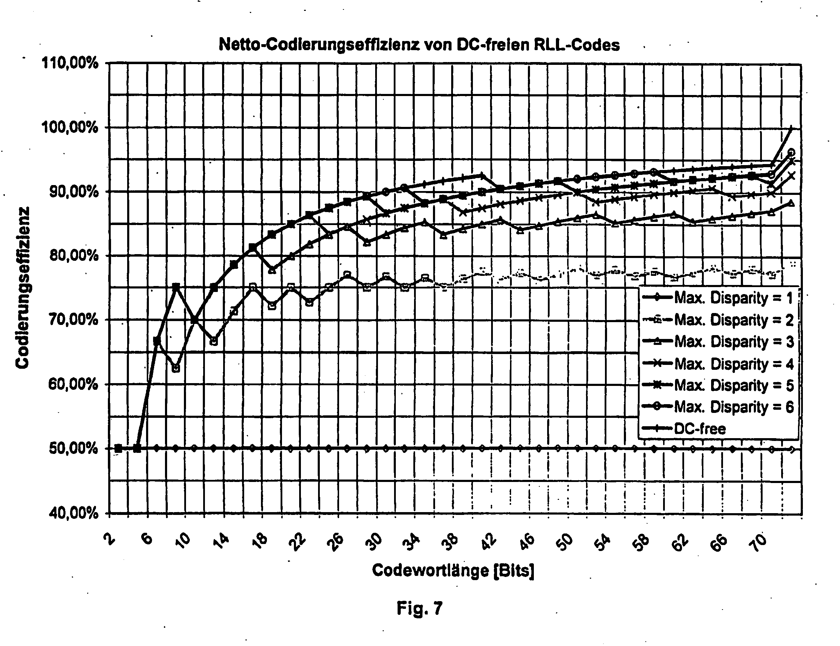

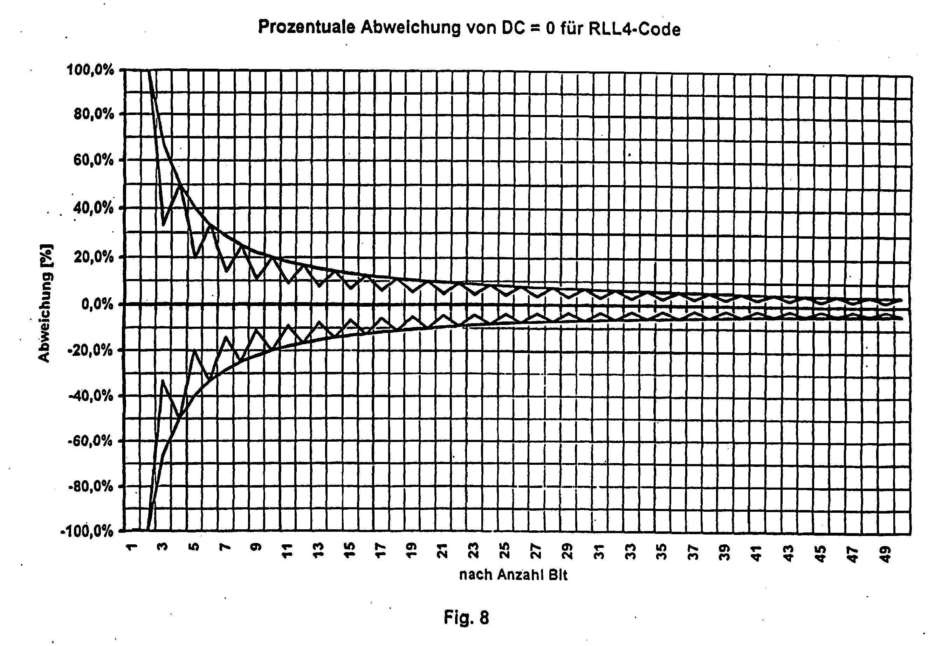

In den Fig. 6, 7 und 8 werden der Netto-Kodierungsoverhead, die Netto-Kodierungseffizienz und die prozentuale Abweichung von der Gleichspannungsfreiheit von RLL-Code als Funktion der Codewortlänge gezeigt.

Die vorliegenden Kodier- und Dekodierverfahren können einfach und platzsparend realisiert werden. Dies spielt besonders für Produkte im Low-Cost-Segment eine wichtige Rolle. Es erzeugt aus einem temären Datenstrom binäre Codes beliebiger Länge, die sich auf einfache Weise in einen Ternärdatenstrom zurück dekodieren lassen. Unter der Randbedingungen von $RLL_{MAX}$ = 4 und $D_{MAX}$ = 2 liegt die Codeeffizienz dabei nahe einem theoretischen Optimum von 79,248%. Ferner kommt das Verfahren ohne speicherintensive Codeworttabellen aus und die Länge der erzeugten Codeworte ist prinzipbedingt nicht beschränkt. Durch das konstante Verhältnis $C_2(2n)/C_2(2n-2)$ lässt sich das Codewort für verschiedene Codewortlängen systematisch konstruieren.

## Patentansprüche

1. Verfahren zum Kodieren von Datenströmen, bei dem zur Kodierung aus einem binären Quelldatenstrom ein binärer Code erzeugt wird, indem der Quelldatenstrom durch eine Basiskonversion in einen temären Datenstrom konvertiert wird derart, dass ein oder mehrere Blöcke mit einer Blocklänge von mehreren Bits Block-werterhaltend in Blöcke von ternären Symbolen konvertiert werden, und aus dem temären Datenstrom mittels Zustandsübergängen (T0, T1, T2) der binäre Code gebildet wird, wobei die Zustandsübergänge (T0, T1, T2) einzeine Ziffern der Temärdarstellung ("0", "1", "2") des ternären Datenstroms jeweils einer Binärkombination aus zwei Binärstellen ("O", "1") des binären Codes zuordnen, **dadurch gekennzeichnet, dass** eine positive oder negative Startdisparität erzeugt wird und die Zustandsübergänge (T0, T1, T2) zur Erzeugung eines binären Codes mit einer maximale Lauflänge von vier aufeinanderfolgenden gleichen diskreten Signalzuständen und einer maximalen Disparität von zwei diskreten Abweichungen von der Pegelmitte zweier Signalzustände oder von dem Nullpegel der Disparität eine eindeutige Abbildung zwischen den temären Signalzuständen ("0", "1", "2") des temären Datenstroms und den Binärkombinationen ("OI", "IO", "OO", "II") bilden, indem ein erster Zustandsübergang (T0 einen ersten temären Signalzustand ("0") auf eine erste gleichspannungsfreie Binärkombination ("OI), ein zweiter Zustandsübergang (T1) einen zweiten temären Signalzustand ("1") auf die zweite gleichspannungsfreie Binärkombination ("IO") und der dritte Zustandsübergang (T2) den dritten temären Signalzustand ("2") in Abhängigkeit von der laufenden Disparität des bisher berücksichtigten binären Codes auf eine Binärkombination ("OO", "II") mit den gleichen binären Signalzuständen entgegensetzter Disparität abbildet.

2. Verfahren zum Dekodieren von Datenströmen mit einer maximale Lauflänge von vier aufeinanderfolgenden gleichen diskreten Signalzuständen und einer maximalen Disparität von zwei diskreten Abweichungen von der Pegelmitte zweier Signalzustände oder von dem Nullpegel der Disparität, bei dem ein binärer Code in einen binären Quelldatenstrom verwandelt wird, indem der binäre Code zur Dekodierung mittels Zustandsübergängen (OI, IO, II, OO) in den temären Datenstrom überfuhrt und der ternäre Datenstrom durch eine Basiskonversion in den binären Quelldatenstrom konvertiert wird, derart dass ein oder mehrere Blöcke Block-werterhaltend in Blöcke von binären Symbolen konvertiert werden wobei die Zustandsübergänge (OI, IO, II, OO) einzelne Ziffern der Temärdarstellung ("0" "1", "2") des temären Datenstroms jeweils einer Binärkombination aus zwei Binärstellen ("O", "I") des binären Codes zuordnen, **dadurch gekennzeichnet, dass** eine positive oder negative Startdisparität erkannt wird und die Zustandsübergänge **(**OI, IO, II, OO) eine eindeutige Abbildung zwischen den temären Signalzuständen ("0, "1", "2") des ternären Datenstroms und den Binärkombinationen ("OI", "IO", "OO", "II") bilden, indem ein erster Zustandsübergang (OI) eine erste gleichspannungsfreie Binärkombination ("OI") auf einen ersten temären Signalzustand ("0"), ein zweiter Zustandsübergang (IO) die zweite gleichspannungsfreie Binärkombination ("IO") auf einen zweiten temären Signalzustand ("1") und ein dritter und vierter Zustandsübergang (II, OO) eine Binärkombination ("II", "OO") mit den gleichen binären Signalzuständen bei einer der laufenden Disparität des bisher berücksichtigten binären Codes entgegengesetzten Disparität der Binärkombination ("II", "OO") auf den dritten temären Signalzustand ("2") abbildet.

3. Verfahren nach Anspruch 2, **dadurch gekennzeichnet, dass** der dritte und vierte Zustandsübergang (II, OO) eine Binärkombination ("II", "OO") mit den gleichen binären Signalzuständen bei einer zu der laufenden Disparität des bisher berücksichtigten binären Codes gleichen Disparität der Binärkombination ("II", "OO") auf eine Ende-der-Nachricht-Anweisung ({}) abbildet.

4. Verfahren nach einem der Ansprüche 1 bis 3, **dadurch gekennzeichnet, dass** zur Erzeugung der Startdisparität ein Startbit oder die Disparität einer vorherigen Bitsequenz verwendet wird.

5. Verfahren nach Anspruch 1 bis 4, **dadurch gekennzeichnet, dass** die Blocklänge des binären Codes 11, 19 oder 84 Bit beträgt.

6. Verfahren nach einem der vorhergehenden Ansprüche, **dadurch gekennzeichnet, dass** dem in binären Code konvertierten Datenstrom eine SYNC-Sequenz vorangestellt wird.

7. Verfahren nach Anspruch 6, **dadurch gekennzeichnet, dass** die SYNC-Sequenz eine Taktsequenz mit einer Folge alternierender Signalpegel und eine Startsequenz mit einer größeren Lauflänge von aufeinanderfolgenden gleichen Signalzuständen als die maximale Lauflänge des Datenstroms aufweist.

8. Verfahren nach Anspruch 6 oder 7, **dadurch gekennzeichnet, dass** die Startsequenz mit einer definierten Disparität endet, insbesondere mit der Disparität null oder einer einfach positiven oder negativen Disparität.

**Claims**

1. A method for coding of data streams by which for coding, a binary code is generated from a binary source data stream by converting the source data stream by means of a basis conversion into a ternary data stream in such a manner that one or more blocks having a block length of multiple bits, while maintaining the block value, are converted into blocks of ternary symbols, and generating the binary code from the ternary data stream by means of the state transitions (T0, T1, T2), wherein the state transitions (T0, T1, T2) assign individual numerals of the ternary representation ("0", "1", "2") of the ternary data stream to each of a binary combination of two binary digits ("O", "I") of the binary code, **characterized in that** a positive or negative start disparity is generated, and the state transitions (T0, T1, T2), for generation of a binary code having a maximum length run-length of four successive equal discrete signal states and a maximum disparity of two discrete deviations from the middle of the level of two signal states or from the zero-level of the disparity, form a definite mapping between the ternary signal states ("0", "1", "2") of the ternary data stream and the binary combinations ("OI", "IO", "OO", "II"), wherein a first state transition (T0) maps a first ternary signal state ("0") onto a first DC-free binary combination ("OI"), a second state transition (T1) maps a second ternary signal state ("1") onto the second DC-free binary combination ("OI") and the third state transition (T2) maps the third ternary signal state ("2"), depending on the current disparity of the previously considered binary code, onto a binary combination ("OO", "II") with the same binary signal states of opposite disparity.

2. A method for decoding of data streams having a maximum run-length of four successive equal discrete signal states and a maximum disparity of two discrete deviations from the middle of the level of two signal states or from the zero-level of the disparity, by which a binary code is transformed into a binary source data stream by transferring the binary code for decoding by means of the state transitions (OI, IO, II, 00) into the ternary data stream and converting the ternary data stream by means of a basis conversion into the binary source data stream, in such a manner that one or more blocks, while maintaining the block value, are converted in blocks of binary symbols, wherein the state transitions (OI, IO, II, 00) assign individual numerals of the ternary representation ("0", "1", "2") of the ternary data stream to each of a binary combination of two binary digits ("O", "I") of the binary code, **characterized in that** a positive or negative start disparity is recognized and the state transitions (OI, IO, II, 00) form a definite mapping between the ternary signal states ("0", "1", "2") of the ternary data stream and the binary combinations ("OI", "IO", "OO", "II"), wherein a first state transition (OI) maps a first DC-free binary combination ("OI") onto a first ternary signal state ("0"), a second state transition (IO) maps the second DC-free binary combination ("IO") onto a second ternary signal state ("1") and a third and fourth state transition (II, 00) map a binary combination ("II", "OO") with the same signal states at a disparity of the binary combination ("II", "OO"), which is opposite to the current disparity of the previously considered binary code, onto the third ternary signal state ("2").

3. The method according to claim 2, **characterized in that** the third and fourth state transition (II, 00) maps a binary combination with the same binary signal states at a disparity of the binary combination ("II", "OO"), which is equal to the disparity of the current disparity of the previously considered binary code, onto an end of message instruction ({}).

4. The method according to any one of the claims 1 to 3, **characterized in that** for generation of the start disparity, a start-bit or the disparity of a previous bit sequence is used.

5. The method according to claim 1 to 4, **characterized in that** the block length of the binary code is 11, 19 or 84 bits.

6. The method according to any one of the preceding claims, **characterized in that** a SYNC sequence is put in front of the data stream converted into binary code.

7. The method according to claim 6, **characterized in that** the SYNC sequence comprises a clock sequence with a sequence of alternating signal levels and a start sequence with a run-length of successive equal signal states higher than the maximum run-length of the data stream.

8. The method according to claim 6 or 7, **characterized in that** the start sequence ends with a defined disparity, in particular with the disparity zero or with a single-positive or negative disparity.

**Revendications**

1. Procédé pour le codage de flux de données, dans lequel un code binaire est généré pour le codage à partir d'un flux binaire de données source en convertissant le flux de données source par une conversion de base en un flux de données ternaire, de telle sorte qu'un ou plusieurs blocs présentent une longueur de bloc de plusieurs blocs binaires sont convertis en conservant la valeur de bloc en blocs de symboles ternaires, et le code binaire est formé partir du flux de données ternaire au moyen de transitions d'état (T0, T1, T2), les transitions d'état (T0, T1, T2) attribuant des chiffres individuels de la représentation ternaire ("0", "1", "2") du flux de données ternaire respectivement une combinaison binaire constituée de deux chiffres binaires ("0", "I"), du code binaire, **caractérisé en ce qu'**une disparité de départ positive ou négative est générée et les transitions d'état (T0, T1, T2) pour générer un code binaire avec une longueur de plage maximale de quatre états de signal discrets identiques et consécutifs et une disparité maximale de deux écarts discrets par rapport au centre du niveau de deux états de signal ou par rapport au niveau 0 de la disparité forment une illustration claire entre les états de signal ("0", "1", "2") ternaires du flux de données ternaire et les combinaisons binaires ("01", "I0", "00", "II") du fait qu'une première transition d'état (T0) représente un premier état de signal ("0") ternaire sur une première combinaison binaire ("01") sans tension continue, une seconde transition d'état (T1) un second état de signal ("1") ternaire sur la seconde combinaison binaire ("I0") sans tension continue et la troisième transition d'état (T2) le troisième état de signal ("2") ternaire en fonction de la disparité courante du code binaire pris en compte jusqu'ici sur une combinaison binaire ("00", "II") avec les mêmes états de signal binaires identiques de disparité opposée.

2. Procédé pour le décodage de flux de données avec une longueur de plage maximale de quatre états de signal discrets, identiques et consécutifs, et une disparité maximale de deux écarts discrets par rapport au centre du niveau de deux états de signal ou par rapport au niveau 0 de la disparité, dans lequel un code binaire est converti en un flux binaire de données source par le fait que le code binaire est converti pour le décodage au moyen de transitions d'état (01, I0, II, 00) dans le flux de données ternaire et le flux de données ternaires est converti par une conversion de base dans le flux binaire de données source, de telle sorte qu'un ou plusieurs blocs sont convertis en conservant la valeur en blocs de symboles binaires, les transitions d'état (01, I0, II, 00) attribuant des chiffres individuels de la représentation ternaire ("0", "1", "2" ) du flux de données ternaire respectivement à une combinaison binaire constituée de deux chiffres binaires ("0", "I") du code binaire, **caractérisé en ce qu'**une disparité de départ positive ou négative est reconnue et les transitions d'état (01, I0, II, 00) forment une illustration évidente entre les états de signal ("0", "1", "2") ternaires du flux de données ternaire et les combinaisons binaires ("0I", "I0", "00", "II") du fait qu'une première transition d'état (0I) représente une première combinaison binaire ("0I") sans tension continue sur un premier état de signal ("0") ternaire, un second état de transition (I0) la seconde combinaison binaire ("I0") sans tension continue sur un second état de signal ("1") ternaire et une troisième et une quatrième transition d'état (II, 00) représentent une combinaison binaire ("II", "00") avec les mêmes états de signal binaires dans le cas d'une disparité, opposée à la disparité courante du code binaire pris en compte jusqu'ici, de la combinaison binaire ("II", "00") sur le troisième état de signal ("2") ternaire.

3. Procédé selon la revendication 2, **caractérisé en ce que** la troisième et la quatrième transition d'état (II, 00) représentent une combinaison binaire ("II", "00") avec les mêmes états de signal binaires dans le cas d'une disparité identique à la disparité courante du code binaire pris en compte jusqu'ici, de la combinaison binaire ("II", "00") sur une directive de fin de message ({}).

4. Procédé selon l'une quelconque des revendications 1 à 3, **caractérisé en ce qu'**un bit de démarrage ou la disparité d'une séquence binaire antérieure est utilisée pour générer la disparité de départ.

5. Procédé selon les revendications 1 à 4, **caractérisé en ce que** la longueur de bloc du code binaire est de 11, 19 ou 84 bits.

6. Procédé selon l'une quelconque des revendications précédentes, **caractérisé en ce qu'**une séquence SYNC est placée en tête du flux de données converti dans le code binaire.

7. Procédé selon la revendication 6, **caractérisé en ce que** la séquence SYNC présente une séquence de rythme avec une succession de niveaux de signal alternatifs et une séquence de démarrage avec une longueur de plage d'états de signal identiques consécutifs qui est supérieure à la longueur de plage maximale du flux de données.

8. Procédé selon la revendication 6 ou 7, **caractérisé en ce que** la séquence de démarrage se termine avec une disparité définie, en particulier avec la disparité zéro ou une disparité simplement positive ou négative.

| Länge 2n Bit | Disparität D = 1 | D = 2 | D = 3 | D = 4 | D = 5 | D = 6 | D = n |
|---|---|---|---|---|---|---|---|
| 2 | 2 | | | | | | 2 |
| 4 | 4 | 6 | | | | | 6 |
| 6 | 8 | 18 | 20 | | | | 20 |
| 8 | 16 | 54 | 68 | 70 | | | 70 |
| 10 | 32 | 162 | 232 | 250 | 252 | | 252 |
| 12 | 64 | 486 | 792 | 900 | 922 | 924 | 924 |
| 14 | 128 | 1458 | 2704 | 3250 | 3404 | 3430 | 3432 |
| 16 | 256 | 4374 | 9232 | 11750 | 12630 | 12838 | 12870 |
| 18 | 512 | 13122 | 31520 | 42500 | 46988 | 48314 | 48620 |
| 20 | 1024 | 39366 | 107616 | 153750 | 175066 | 182476 | 184756 |
| 22 | 2048 | 118098 | 367424 | 556250 | 652764 | 690802 | 705432 |
| 24 | 4096 | 354294 | 1254464 | 2012500 | 2434966 | 2619148 | 2704156 |
| 26 | 8192 | 1062882 | 4283008 | 7281250 | 9085052 | 9940140 | 10400600 |
| 28 | 16384 | 3188646 | 14623104 | 26343750 | 33901146 | 37748522 | 40116600 |
| 30 | 32768 | 9565938 | 49926400 | 95312500 | 126511340 | 143411730 | 155117520 |
| 32 | 65536 | 28697814 | 170459392 | 344843750 | 472127830 | 544983782 | 601080390 |
| 34 | 131072 | 86093442 | 581984768 | 1247656250 | 1761967212 | 2071361908 | 2333606220 |
| 36 | 262144 | 258280326 | 1987020288 | 4514062500 | 6575675482 | 7873642518 | 9075135300 |
| 38 | 524288 | 774840978 | 6784111616 | 16332031250 | 24540603644 | 29931317388 | 35345263800 |
| 2n | $2^n$ | $2 \times 3^{(n-1)}$ | | | | | |

**Fig. 1**

**Fig. 2**

**Fig. 3**

-1  0-1  0-1  0-1  0      -1  0+1+2+1  0-1-2-3-2-1  0-1  0   *Disparität der*

0  1  0  1  0  1  0  1...  0  1  1  1  0  0  0  0  0  1  1  1  0  1  **SYNC-**

Taktsequenz                    Startsequenz            **Sequenz**

**Fig. 4a**

+1  0+1  0+1  0+1  0      +1  0-1-2-1  0+1+2+3+2+1  0+1  0   *Disparität der*

1  0  1  0  1  0  1  0...  1  0  0  0  1  1  1  1  1  0  0  0  1  0  **SYNC-**

Taktsequenz                    Startsequenz            **Sequenz**

**Fig. 4b**

**Fig. 5**

Netto-Codierungsoverhead von DC-freien RLL-Codes

Fig. 6

Codewortlänge [Bits]

Netto-Overhead

Max. Disparity = 1
Max. Disparity = 2
Max. Disparity = 3
Max. Disparity = 4
DC-free

**Netto-Codierungseffizienz von DC-freien RLL-Codes**

Fig. 7

EP 1 261 137 B1

Prozentuale Abweichung von DC = 0 für RLL4-Code

nach Anzahl Bit

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4486739 A
- US 5271016 A